# EUROPEAN PATENT SPECIFICATION

(11) **EP 0 494 184 B1**
(45) Date of publication and mention of the grant of the patent: **14.04.1999**
(21) Application number: 90913984.2
(22) Date of filing: 17.09.1990
(51) Int. Cl.: H01L 27/088, H01L 27/11, H01L 29/78

(54) **MOS DEVICE WITH INTEGRAL ESD PROTECTION**
MOS-ANORDNUNG MIT VOLLSTÄNDIGEM ESD-SCHUTZ
DISPOSITIF MOS COMPRENANT UNE PROTECTION INTEGREE CONTRE LA DECHARGE ELECTROSTATIQUE

(30) Priority: 27.09.1989 GB 8921841
(43) Date of publication of application: 15.07.1992
(73) Proprietor: SHARP CORPORATION, Tenri, Nara 632 (JP)
(72) Inventor: AVERY, Leslie, Ronald, Hunterdon, NJ 08822 (US)
(74) Representative: Williams, Janice
(86) International application number: US9005175
(87) International publication number: WO9105371

(56) References cited:
- GB-A- 2 176 053
- JP-A- 0 021 965
- JP-A-60 158 671
- US-A- 4 845 536
- US-A- 4 937 471

## Description

### Background of the Invention

Many attempts have been made in the prior art to protect semiconductor devices, including bipolar transistors, field effect devices, and integrated circuit against damage due to voltage and current transients. Some of such protection circuits are described in the United States patents to Stewart, No. 3,967,295, Khajezadeh, No. 4,106,048, Kim. No. 4,342,045, Igarashi, No. 4,656,491, Shirato et al, No. 4,710,791, Leuschner, NO. 4,724,471, Sato, No. 4,739,438, Hatta et al, No. 4,803,527, Clark, No. 4,807,080 and Chen et al, No. 4,825,280.

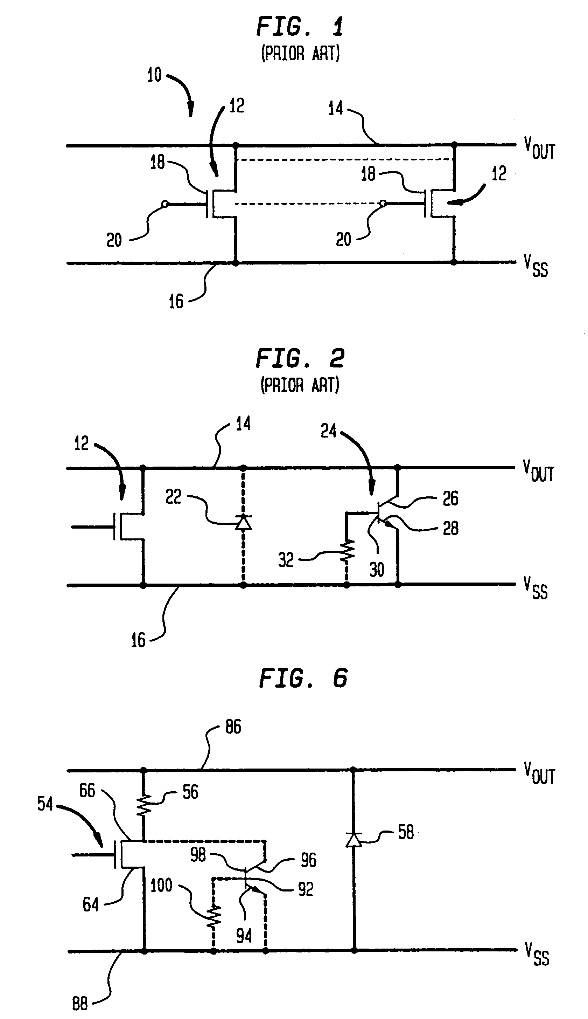

A particular problem with integrated circuit which include field effect transistors has been their protection from electrostatic discharge (ESD). One type of output circuit which has been used for this purpose is shown in Fig. 1 and is generally indicated as 10. The output circuit 10 includes a plurality of NMOS transistors 12 connected in parallel between an output voltage line 14 and a reference voltage line 16. The gate electrode 18 of each transistor 12 is connected to a common gate terminal 20. The NMOS transistors 12 typically provide a nominal level of protection against electrostatic discharge (ESD) by a parasitic diode 22, shown in phantom in Fig. 2, with its cathode electrode connected to the output voltage line 14 and its anode electrode connected to the reference voltage line 16. The parasitic diode 22 protects against negative voltage transients by shunting the transient energy away from the associated NMOS transistor 12. Each NMOS transistor 12 also provides a parasitic NPN transistor 24, also shown in Fig. 2. Parasitic transistor 24 has its collector electrode 26 and its emitter electrode 28 connected to output voltage line 14 and reference voltage line 16 respectively. The base electrode 30 of transistor 24 is connected via a parasitic resistance 32 to the reference voltage line 16. The parasitic NPN transistor 24 protects against positive voltage transients. When the level of a positive transient voltage exceeds the V_{cer} capability of transistor 24, the transistor 24 breaks down and conducts the transient energy from output line 14 to reference line 16, limiting the transient voltage across the associated NMOS transistor 12.

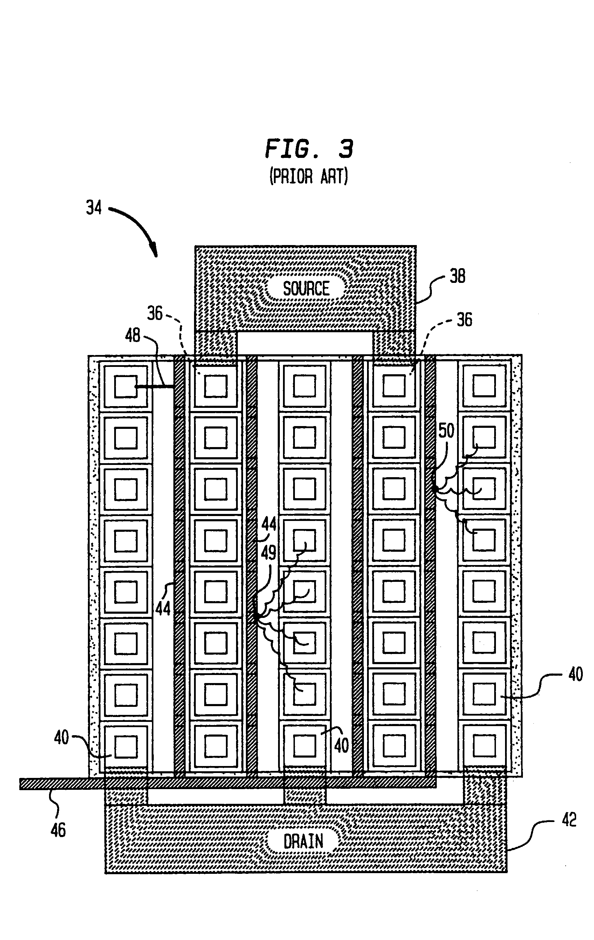

Referring to Fig. 3, there is shown a prior art NMOS output transistor array 34 comprised of a plurality of NMOS transistors 12 connected in parallel. The source regions 36 of the transistors 12 are connected to a common source electrode 38, the drain regions 40 are connected to a common drain electrode 42 and the gate electrodes 44 are connected in common to a primary gate electrode 46. In the array 34, the parasitic diodes 22 are limited in the protection they provide due to their relatively high series resistance. Also, the parasitic transistors 24 are limited in the positive transient protection they provide due to the local concentration of transient current, typically called current focusing.

One technique which has been used to improve the ESD protection provided by the NMOS transistors 12 is to increase the spacing between the gate region and the drain contacts of the transistors by making a long active area region 48, as shown in Fig. 3. This particular technique only offers about a factor of two to three improvement in transient energy handling capability of the array 34, due to the occurrence of current focusing, caused by two or more drain contacts feeding current to a common breakdown region. The current focusing is illustratively shown by the wavy lines in Fig. 3 as occurring at common breakdown regions 49 and 50 which are being fed current from a plurality of drain contacts 40.

In order to prevent the occurrence of current focusing in an NMOS output transistor array , it is necessary to insure that only one contact can deliver current to a given drain/gate region, and that sufficient resistance is added to the drain region to limit the current flow therethrough. Also, it has been found that the parasitic diode 22 associated with an NMOS transistor 12 is unreliable, and that the diode must be formed deliberately in order to provide protection against negative voltage transients. Therefore, it is desirable to have a NMOS transistor protection circuit which eliminates or reduces current focusing in an array and provides a protection diode therein.

US Patent No. US-A-4,845,536 discloses a field effect transistor with insulated gate electrode in which the drain diffusion zone and/or the source diffusion zone is divided into a plurality of parallel strips between the associated drain or source electrode and the intervening channel zone to protect the transistor against electrostatic discharge.

### Summary of the Invention

According to the present invention there is provided a protection circuit as defined in claim 1.

Embodiments of the invention provide an improved NMOS output transistor which has improved current limiting, which provides for substantially reduced current focusing when connected in an array, and includes a deliberately formed diode for improved protection from negative transients. Embodiments of the invention also provide a structure which includes a plurality of individual NMOS transistors connected in parallel and formed on a common substrate with means for both limiting the current flow in the drain/gate region of an NMOS transistor and providing electrical isolation between the various drain contacts, thereby substantially insuring that only one drain contact can conduct current to an associated gate region, thereby preventing current concentration from adjacent drain contacts.

### Brief Description of the Drawings

Fig. 1 is a partial schematic circuit diagram of a prior art integrated circuit output transistor configuration.

Fig. 2 is a schematic circuit diagram showing parasitic ESD and transient voltage protective elements provided by each parallel connected transistor of Fig. 1.

Fig. 3 is a top plan view of an integrated circuit including the structural layout for a typical prior art NMOS output transistor array.

Fig. 4 is a cross section of one form of an NMOS output transistor structure of the present invention.

Fig. 5 is a top plan view of the transistor shown in Fig. 4.

Fig. 6 is a schematic circuit diagram of the transistor shown in Figs. 4 and 5.

Fig. 7 is a top plan view of the structural layout of a NMOS output transistor array embodying the present invention.

### Detailed Description of Preferred Embodiment

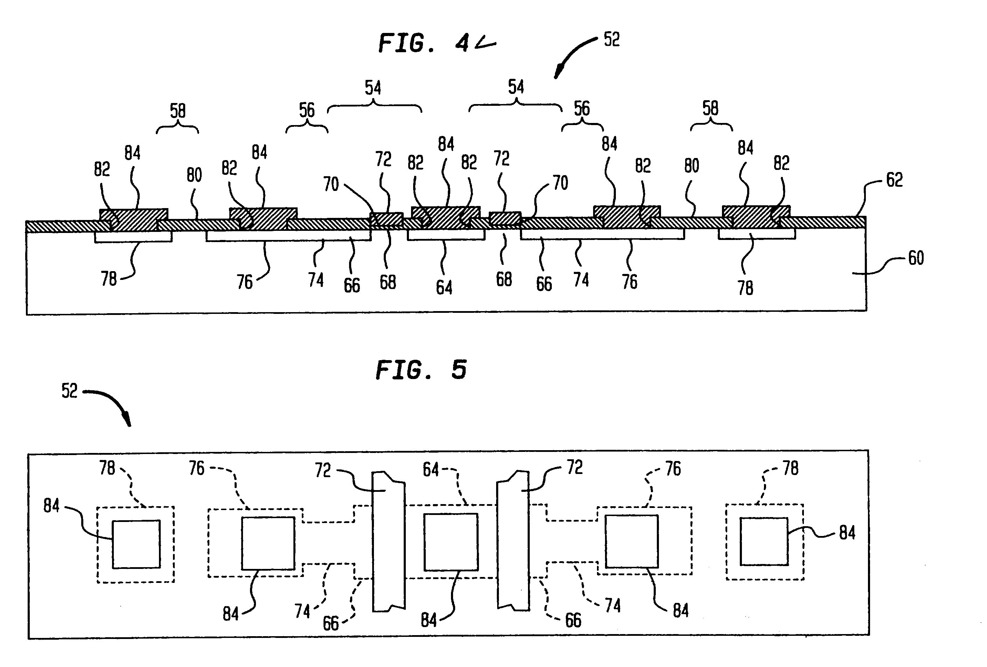

Referring to Figs. 4 and 5, there is shown a form of a cell 52 of the protection circuit of the present invention. The cell 52 comprises two NMOS transistors 54, two resistors 56 and two diodes 58. The cell 52 is formed in a substrate 60 of a semiconductor material, such as single crystalline silicon, of lightly doped P-type conductivity (P-) having a doping concentration of about 10¹³ cm⁻³. It should be noted that instead of forming the cell 52 in a P- substrate 60, it can be formed in a P- well in the substrate 60. In the substrate 60 at its surface 62 is a centrally located highly conductive N-type conductivity (N+) source region 64 having a doping concentration of about 10¹⁸ cm⁻³. In the substrate 60 at the surface 62 and at opposite sides of the source region 64 are highly conductive N-type conductivity (N+) drain regions 66. The drain regions 66 are spaced from the source region 64 to form channel regions 68 in the substrate 60 between the source region 64 and each of the drain regions 66. A thin layer 70 of an insulating material, such as silicon dioxide, is on the substrate surface 62 over each of the channel regions 68, and a conductive gate 72, typically of doped polycrystalline silicon, is on each of the channel insulating layers 70. Thus, the source region 64, drain region 66 and gates 72 form the transistors 54.

Each of the drain regions 66 has an extension 74 extending therefrom away from the source region 64. The extension 74 is narrower than the drain region 66 and forms a resistor 56. At the end of each of the extensions 74 away from the drain region 66 is a contact pad region 76 which is wider than the extension 74 but narrower than the drain region 66. In the substrate 60 adjacent to but spaced from each of the contact pad regions 76 is a region 78 of highly conductive P-type conductivity (P+). The region 78 serves as the contact pad for the anode of a diode 58 formed between the N+ type contact pad region 76 and the P- substrate 60. A layer 80 of an insulating material, such as silicon oxide or a glass, is over the substrate surface 62 and covers the source region 64, the drain regions 66, resistors extensions 74, contact pad regions 76 and P+ regions 78. The insulating layer 80 has openings 82 therethrough over the source region 64, each of the contact pad regions 76 and each of the P+ regions 78. Separate metal contacts 84 extend through the openings 80 to make electrical contact with each of the regions at the bottom of the openings.

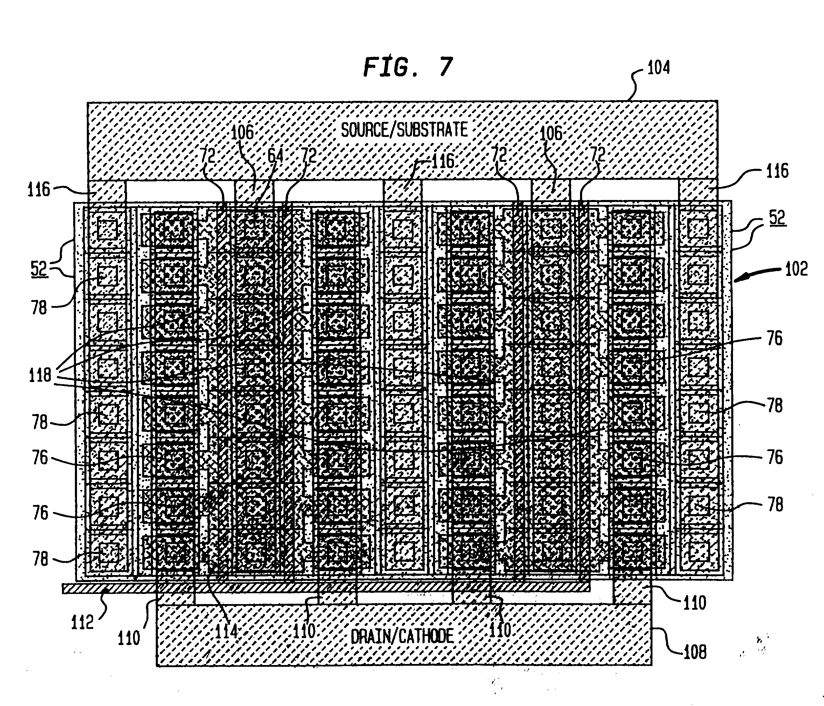

Referring to Fig. 6, there is shown a simplified schematic circuit diagram of one-half of a cell 52. The drain 66 of a NMOS transistor 54 is connected through a resistor 56, formed by the extension 74, to an output voltage line 86, and the source 64 is connected to a reference voltage line 88. The diode 58 formed between the bonding pad 76 and the substrate 60 is connected between the output voltage line 86 and the reference voltage line 88 in parallel with the transistor 54. In the cell 52 there is formed a parasitic NPN transistor 92 which has an emitter 94 provided by the source region 64 of the transistor 56, a collector 96 provided by the drain region 66 of the transistor 56 and a base 98 provided by the substrate 60. The substrate 60 also provides a base resistor 100.

Fig. 7 shows an NMOS output transistor array 102 comprising a plurality of the cells 52 connected in parallel with one another. The cells 52 are arranged in a plurality of columns with the source regions 64 of the transistors 54 in each column being connected to a source contact pad 104 by a common connecting strip 106. The drain contact pads 76 are connected to a common drain contact pad 108 by a common connecting strip 110. The gates 72 are connected to a gate bus 112 by a connecting strip 114. The anode pad regions 78 are electrically connected to the source contact pad 104 by connecting strips 116.

In the operation of the array 102 having the cells 52 embodying the present invention, only one drain contact pad region 76 can feed current to an associated channel region 68. Under a positive transient voltage, the parasitic NPN transistor 92 of a given cell 52 goes into a "snap-back" mode of operation at a given current level, and the main power dissipation occurs at the associated gate/drain area. If one such gate/drain area tends to break down at a lower voltage than other gate/drain areas, current concentration is by the drain contact pads 76 being spaced from the drain region 66 and by the resistor extension 74 therebetween. Also, since the resistor extension 74 are narrower than the drain regions 66, there is provided relatively large spaces 118, see Fig. 7, between each drain pad region 76 and the drain region 66 of adjacent transistors 56. These spaces 118 electrically isolate the drain pad regions 76 from the drain regions 66 of adjacent transistors 56 so as to prevent current focusing. The insulating layer 80 which extends over the substrate surface 64 including the spaces 118 provides additional insulation in the spaces 118. Finally, in the array 102, each of the diodes 58 is specifically formed so that it is more reliable than the previously provided parasitic diode to insure proper operation of the protection circuit. Thus, there is provided by, this embodiment of the present invention an NMOS protection circuit which includes an array of NMOS transistors which provides the desired protection against electrostatic discharge and minimizes current focusing.

Modification of the various embodiments of the invention may occur to one skilled in the art. For example, while the exemplary embodiment has been described in terms of particular conductivity types, converse conductivity types may be used so long as the relative conductivity types remain the same.

## Claims

1. A protection circuit comprising a plurality of cells (52) arranged in columns and connected in parallel in an array, each of the cells comprising:
a common substrate (60) of a first conductivity type having a surface (62);
a first region (64) of second conductivity type in the substrate at said surface forming a source (64) of a MOS transistor (54);
a second region (66) of the second conductivity type in the substrate at said surface, and spaced from the first region (64), forming a drain (66) of the transistor (54), the portion (68) of the substrate between the first and second regions forming the channel (68) of the transistor (54);
gate means (72) overlying and insulated from the substrate surface over the channel (68) between the first and second regions (64,66);
an extension (74) of said second region (66) extending from the second region along the substrate surface in a direction away from the channel (68), said extension being narrower than the second region;
a drain contact region (76) of the second conductivity type of relatively high conductivity in said substrate surface at the end of the extension (74) the drain contact region (76) being narrower than the second region (66) but wider than the extension (74); and
a third region (78) of the first conductivity type of relatively high conductivity formed in the substrate (60) at said surface, said third region being adjacent to but spaced from the drain contact region (76) and forming the contact for one side of a diode (58) formed between the substrate (60) and the drain contact region (76).

2. A circuit as claimed in claim 1 including a layer (80) of an insulating material over the surface of the substrate (60), wherein the gate (72) is formed on a portion (70) of the insulating layer (80) over the channel (68).

3. A circuit as claimed in claim 2 having separate conductor means (84) extending through openings (82) in the insulating layer (80) and contacting the first, second and third regions (64,66,78) respectively.

4. A circuit as claimed in claim 1 including a fourth region (66) of the second conductivity type in the substrate (60) at said surface on the opposite side of the first region (64) to the second region (66), said fourth region (66) being spaced from the first region (64) to form a second drain region with a second channel (68) between the first and fourth regions, and a second gate (72) overlying and insulated from the surface of the substrate along said second channel.

5. A circuit as claimed in claim 4 including an extension (74) of the fourth region (66) extending from the fourth region along said substrate surface in a direction away from the second channel (68), said extension being narrower than the fourth region.

6. A circuit as claimed in claim 5 including a drain contact region (76) of the second conductivity type and of relatively high conductivity in the substrate surface at the end of the extension (74) of the fourth region (66).

7. A circuit as claimed in claim 6 including a fifth region (78) of the first conductivity type of relatively high conductivity formed in the substrate (60) at said surface, said fifth region (78) being adjacent to but spaced from the drain contact region (76) for the fourth region (66) and forming the contact for one side of a diode (58) formed between the substrate (60) and the drain contact region for the fourth region.

8. A circuit as claimed in claim 6 or claim 7 in which the drain contact region (76) for the fourth region (66) is wider than the extension (74) of the fourth region (66) but narrower than the fourth region (66).

9. A circuit as claimed in claim 7 including a layer (80) of an insulating material over the substrate surface, wherein the gates (72) are formed on the insulating material over their respective channels (68).

10. A circuit as claimed in claim 9 including separate conductors (84) extending through the insulating layer (80) and electrically contacting the first, second, third, fourth and fifth regions respectively.

11. A circuit as claimed in claim 10, wherein in each column means (106,110,116) are provided to electrically connect together the conductors (84) for the first, second, third, fourth and fifth regions respectively.

12. A circuit as claimed in claim 11 in which the means (106) electrically connecting together the first regions (64) of each of the columns are electrically connected to a common source terminal pad (104), the means (110) electrically connecting the second and fourth regions (66) are electrically connected to a common drain terminal pad (108), the means (116) electrically connecting the third and fifth regions (78) are electrically connected to the source terminal pad (104), and the gates (72) are electrically connected to a common gate bus (112) by a connecting strip (114).

13. A circuit as claimed in any preceding claim wherein said MOS transistor (54) is an NMOS transistor.

## Patentansprüche

1. Schutzschaltung mit einer Anzahl von in Spalten angeordneten Zellen (52), die in einem Array angeschlossen sind, wobei jede der Zellen Folgendes aufweist:
- ein gemeinsames Substrat (60) von erstem Leitungstyp mit einer Oberfläche (62);
- einen ersten Bereich (64) von zweitem Leitungstyp im Substrat an der Oberfläche, der eine Source (64) eines MOS-Transistors (54) bildet;
- einen zweiten Bereich (66) vom zweiten Leitungstyp im Substrat an der Oberfläche, der vom ersten Bereich (64) beabstandet ist und einen Drain (66) des Transistors (54) bildet, wobei der Teil (68) des Substrats zwischen dem ersten und zweiten Bereich den Kanal (68) des Transistors (54) bildet;
- eine Gateeinrichtung (72), die über dem Kanal (68) zwischen dem ersten und zweiten Bereich (64, 66) liegt und gegen die Substratoberfläche isoliert ist;
- eine Verlängerung (74) des zweiten Bereichs (66), die sich vom zweiten Bereich entlang der Substratoberfläche in einer Richtung weg vom Kanal (68) erstreckt und schmaler als der zweite Bereich ist;
- einen Drainkontaktbereich (76) vom zweiten Leitungstyp mit relativ hoher Leitfähigkeit an der Substratoberfläche am Ende der Verlängerung (74), wobei dieser Drainkontaktbereich (76) schmaler als der zweite Bereich (66) jedoch breiter als die Verlängerung (74) ist; und
- einen dritten Bereich (78) vom ersten Leitungstyp mit relativ hoher Leitfähigkeit, der im Substrat (60) an der genannten Oberfläche ausgebildet ist und benachbart zum Drainkontaktbereich (76), jedoch beabstandet von diesem liegt und den Kontakt für eine Seite einer Diode (58) bildet, die zwischen dem Substrat (60) und dem Drainkontaktbereich (76) ausgebildet ist.

2. Schaltung nach Anspruch 1, mit einer Schicht (80) eines isolierenden Materials auf der Oberfläche des Substrats (60), wobei das Gate (72) in einem Teil (70) der isolierenden Schicht (80) über dem Kanal (68) ausgebildet ist.

3. Schaltung nach Anspruch 2, mit einer gesonderten Leitereinrichtung (84), die sich durch Öffnungen (82) in der Isolierschicht (80) erstreckt und mit dem ersten, zweiten und dritten Bereich (64, 66, 78) in Kontakt steht.

4. Schaltung nach Anspruch 1, mit einem vierten Bereich (66) vom zweiten Leitungstyp im Substrat (60) an der Oberfläche auf der entgegengesetzten Seite des ersten Bereichs (64) in Bezug auf den zweiten Bereich (66), wobei dieser vierte Bereich (66) vom ersten Bereich (64) beabstandet ist, um einen zweiten Drainbereich mit einem zweiten Kanal (68) zwischen dem ersten und vierten Bereich auszubilden, und mit einem zweiten Gate (72), das über der Oberfläche des Substrats entlang dem zweiten Kanal liegt und gegen diese isoliert ist.

5. Schaltung nach Anspruch 4, mit einer Verlängerung (74) des vierten Bereichs (66), die sich vom vierten Bereich entlang der Substratfläche in einer Richtung weg vom zweiten Kanal (68) erstreckt und die schmaler als der vierte Bereich ist.

6. Schaltung nach Anspruch 5, mit einem Drainkontaktbereich (76) vom zweiten Leitungstyp und mit relativ hoher Leitfähigkeit in der Substratoberfläche am Ende der Verlängerung (74) des vierten Bereichs (66).

7. Schaltung nach Anspruch 6, mit einem fünften Bereich (78) vom ersten Leitungstyp mit relativ hoher Leitfähigkeit, der im Substrat (60) in der genannten Oberfläche ausgebildet ist und benachbart zum Drainkontaktbereich (76) für den vierten Bereich (66) liegt, jedoch von diesem beabstandet ist, und den Kontakt für eine Seite einer Diode (58) bildet, die zwischen dem Substrat (60) und dem Drainkontaktbereich für den vierten Bereich ausgebildet ist.

8. Schaltung nach Anspruch 6 oder Anspruch 7, bei der der Drainkontaktbereich (76) für den vierten Bereich (66) breiter als die Verlängerung (74) des vierten Bereichs (66), jedoch schmaler als der vierte Bereich (66 ist.

9. Schaltung nach Anspruch 7, mit einer Schicht (80) aus einem isolierenden Material über der Substratfläche, wobei die Gates (72) auf dem isolierenden Material über ihren jeweiligen Kanälen (68) ausgebildet sind.

10. Schaltung nach Anspruch 9, mit gesonderten Leitern (84), die sich durch die Isolierschicht (80) erstrecken und den ersten, zweiten, dritten, vierten und fünften Bereich kontaktieren.

11. Schaltung nach Anspruch 10, bei der in jeder Spalte Einrichtungen (106, 110, 116) vorhanden sind, um die Leiter (84) für den ersten, zweiten, dritten, vierten bzw. fünften Bereich elektrisch miteinander zu verbinden.

12. Schaltung nach Anspruch 11, bei der die Einrichtung (106), die die ersten Bereiche (64) jeder der Spalten elektrisch miteinander verbindet, elektrisch mit einem gemeinsamen Sourceanschluss-Kontaktkissen (104) verbunden ist, die Einrichtung (110), die den zweiten und vierten Bereich (66) elektrisch miteinander verbindet, mit einem gemeinsamen Drainanschluss-Kontaktkissen (108) verbunden ist, die Einrichtung (116), die den dritten und fünften Bereich (78) elektrisch miteinander verbindet, elektrisch mit dem Sourceanschluss-Kontaktkissen (104) verbunden ist, und die Gates (72) über einen Verbindungsstreifenleiter (114) elektrisch mit einem gemeinsamen Gatebus (112) verbunden sind.

13. Schaltung nach einem der vorstehenden Ansprüche, bei der der MOS-Transistor (54) ein NMOS-Transistor ist.

## Revendications

1. Circuit de protection comprenant une multiplicité de cellules disposées en colonnes et reliées en parallèle suivants une matrice, chacune des cellules comprenant:
un substrat commun (60) d'un premier type de conductivité ayant une surface (62);
une première région (64) d'un second type de conductivité située dans le substrat au niveau de ladite surface et formant une source (64) d'un transistor NMOS (54);
une seconde région (66) du second type de conductivité située dans le substrat au niveau de ladite surface en étant espacée de la première région (64), formant un drain (66) du transistor (54), la partie (68) du substrat située entre les première et seconde régions formant le canal (68) du transistor (54);
des moyens formant grille (72) recouvrant, en en étant isolés, la surface du substrat au-dessus du canal (68) situé entre les première et seconde régions (64, 66);
un prolongement (74) de ladite seconde région (66) s'étendant à partir de la seconde région, le long de la surface du substrat, dans une direction s'éloignant du canal (68), ledit prolongement étant plus étroit que la seconde région;
une région de contact de drain (76) du second type de conductivité, présentant une conductivité relativement élevée et située dans ladite surface du substrat à l'extrémité du prolongement (74), la région de contact de drain (76) étant plus étroite que la seconde région (66) mais plus large que le prolongement (74); et
une troisième région (78) du premier type de conductivité présentant une conductivité relativement élevée et formée dans le substrat (60) au niveau de ladite surface, ladite troisième région étant située à côté mais à distance de la région de contact de drain (76) et formant le contact pour un côté d'une diode (58) formée entre le substrat (60) et la région de contact de drain (76).

2. Circuit selon la revendication 1 comprenant une couche (80) de matériau isolant située sur la surface du substrat (60), dans lequel la grille (72) est formée sur une partie (70) de la couche isolante (80), au-dessus du canal (68).

3. Circuit selon la revendication 2 comportant des moyens formant conducteurs séparés (84) s'étendant, à travers les ouvertures (82) dans la couche isolante (80) et en contact avec les première, seconde et troisième régions (64, 66, 78), respectivement.

4. Circuit selon la revendication 1 comprenant une quatrième région (66) du second type de conductivité située dans le substrat (60) au niveau de ladite surface du côté de la première région (64) opposé à la seconde région (66), ladite quatrième région (66) étant espacée de la première région (64) afin de former une seconde région de drain comportant un second canal (68) entre les première et quatrième régions, et une seconde grille (72) recouvrant, en en étant isolée, la surface du substrat le long dudit second canal.

5. Circuit selon la revendication 4 comprenant un prolongement (74) de la quatrième région (66) s'étendant à partir de la quatrième région, le long de ladite surface du substrat, dans une direction s'éloignant du second canal (68), ledit prolongement étant plus étroit que ladite quatrième région.

6. Circuit selon la revendication 5 comprenant une région de contact de drain (76) du second type de conductivité et présentant une conductivité relativement élevée, située dans la surface du substrat à l'extrémité du prolongement (74) de la quatrième région (66).

7. Circuit selon la revendication 6 comportant une cinquième région (78) du premier type de conductivité, présentant une conductivité relativement élevée et formée dans le substrat (60) au niveau de ladite surface, ladite cinquième région (78) étant voisine mais espacée de la région de contact de drain (76) pour la quatrième région (66) et formant le contact pour un côté d'une diode (58) formée entre le substrat (60) et la région de contact de drain pour la quatrième région.

8. Circuit selon la revendication 6 ou la revendication 7, dans lequel la région de contact de drain (76) pour la quatrième région (66) est plus large que le prolongement (74) de la quatrième région (66) mais plus étroite que la quatrième région (66).

9. Circuit selon la revendication 7, comprenant une couche (80) de matériau isolant au-dessus de la surface du substrat, dans lequel les grilles (72) sont formées sur le matériau isolant au-dessus de leurs canaux respectifs (68).

10. Circuit selon la revendication 9, comportant des conducteurs séparés (84) s'étendant à travers la couche isolante (80) et étant en contact électrique avec les première, seconde, troisième, quatrième et cinquième régions, respectivement.

11. Circuit selon la revendication 10, dans lequel, dans chaque colonne, sont prévus des moyens (106, 110, 116) pour relier électriquement ensemble les conducteurs (84) correspondant aux première, seconde, troisième, quatrième et cinquième régions, respectivement.

12. Circuit selon la revendication 11, dans lequel les moyens (106) reliant électriquement les unes aux autres les première régions (64) de chacune des colonnes sont reliés électriquement à une plage de connexion de source commune (104), les moyens (110) reliant électriquement les seconde et quatrième régions (66) sont reliés électriquement à une plage de connexion de drain commune (108), les moyens (116) reliant électriquement les troisième et cinquième régions (78) sont reliés électriquement à la plage de connexion de source (104), et les grilles (72) sont reliées électriquement à un bus de grille commun (112) par une barrette de connexion (114).

13. Circuit selon l'une quelconque des revendications précédentes, dans lequel ledit transistor MOS (54) est un transistor NMOS.
